# FASCICULE DE BREVET EUROPEEN

(11) **EP 1 851 358 B1**
(45) Date de publication et mention de la délivrance du brevet: **02.07.2008**
(21) Numéro de dépôt: 06709520.8
(22) Date de dépôt: 16.02.2006
(51) Int. Cl.: C23C 16/455, C23C 16/458, C23C 16/04

(54) **PROCEDE DE DENSIFICATION DE SUBSTRATS POREUX MINCES PAR INFILTRATION CHIMIQUE EN PHASE VAPEUR ET DISPOSITIF DE CHARGEMENT DE TELS SUBSTRATS**
VERFAHREN ZUR VERDICHTUNG VON DÜNNEN PORÖSEN SUBSTRATEN MITTELS CHEMISCHER INFILTRATION IN DER DAMPFPHASE UND VORRICHTUNG ZUR BELADUNG DERARTIGER SUBSTRATE
METHOD FOR THE DENSIFICATION OF THIN POROUS SUBSTRATES BY MEANS OF VAPOUR PHASE CHEMICAL INFILTRATION AND DEVICE FOR LOADING SUCH SUBSTRATES

(30) Priorité: 17.02.2005 FR 0501615
(43) Date de publication de la demande: 07.11.2007
(73) Titulaire: Snecma Propulsion Solide, 33187 Le Haillan Cedex (FR)
(72) Inventeur: LAMOUROUX, Franck, 33320 Le Taillan Medoc (FR); BERTRAND, Sébastien, 33480 Moulis-en-Medoc (FR); GOUJARD, Stéphane, 33700 Erignac (FR); CAILLAUD, Alain, 33880 Saint Caprais de Bordeaux (FR); BAGILET, Francis, 33370 Tresses (FR); MAZEREAU, Stéphane, 33160 Saint Aubin de Medoc (FR)
(74) Mandataire: Desormiere, Pierre-Louis
(86) Numéro de dépôt international: PCT/FR2006/050141
(87) Numéro de publication internationale: WO 2006/087495

(56) Documents cités:
- EP-A- 1 285 976
- WO-A-96/15285
- US-A1- 2004 071 877

## Description

### Arrière-plan de l'invention

La présente invention concerne les techniques d'infiltration chimique en phase vapeur utilisées notamment lors de la réalisation de pièces en matériau composite thermostructural. Elle concerne plus particulièrement la densification par dépôt de matrice de substrats poreux minces, c'est-à-dire des substrats qui présentent des épaisseurs relativement faibles par rapport à leurs dimensions principales.

Pour la fabrication de pièces en matériau composite, en particulier de pièces en matériau composite thermostructural constituées d'une préforme fibreuse réfractaire (fibres carbone ou céramique, par exemple) densifiée par une matrice réfractaire (carbone ou céramique, par exemple), il est courant de faire appel à des procédés d'infiltration chimique en phase vapeur. Des exemples de telles pièces sont des tuyères de propulseurs en composite carbone-carbone (C-C), ou des disques de freins, notamment de freins d'avions, en composites C-C.

La densification de substrats poreux par infiltration chimique en phase vapeur consiste à placer les substrats dans une chambre de réaction d'une installation d'infiltration au moyen d'un outillage de support et à admettre dans la chambre un gaz réactif dont un ou plusieurs constituants sont des précurseurs du matériau à déposer au sein des substrats afin d'assurer leur densification. Les conditions d'infiltration, notamment composition et débit du gaz réactif, et température et pression dans la chambre sont choisies pour permettre une diffusion du gaz au sein de la porosité interne accessible des substrats afin qu'y soit déposé le matériau désiré par décomposition d'un constituant du gaz ou réaction entre plusieurs constituants de celui-ci. Le préchauffage du gaz réactif est habituellement réalisé par passage du gaz à travers une zone de préchauffage située dans la chambre de réaction et dans laquelle s'ouvre l'entrée du gaz réactif. Ce procédé correspond au procédé d'infiltration chimique en phase vapeur à flux libre.

Dans une installation industrielle d'infiltration chimique en phase vapeur, il est habituel de charger la chambre de réaction avec plusieurs substrats ou préformes à densifier simultanément pour augmenter le rendement du procédé de densification et, par conséquent, le taux de chargement des chambres de réaction. Toutefois, la densification par infiltration chimique en phase vapeur à flux libre de plusieurs substrats dans une même chambre entraîne certaines difficultés notamment en ce qui concerne l'uniformité de la densification obtenue. Dans le cas de la densification de substrats minces, ayant par exemple la forme de fines plaques rectangulaires disposées longitudinalement dans une chambre de réaction avec diffusion en flux libre d'un gaz réactif à partir du bord supérieur de celles-ci, il a été constaté la présence de gradients de densification dans les substrats et entre les substrats au sein d'une même chambre (dispersion), et ce en dépit du soin apporté au contrôle des conditions d'infiltration. Ces gradients de dépôt sont dus notamment au manque de maîtrise de l'écoulement du gaz réactif dans la chambre (apparition d'écoulements privilégiés), ce qui entraîne un appauvrissement prématuré des réactifs et, par conséquent, des dispersions de densification entre les parties des substrats les plus proches et les plus éloignées des points d'admission du gaz.

Outre le manque d'uniformité de dépôt observé, la densification de substrats minces nécessite actuellement l'utilisation d'outils de maintien afin de limiter la déformation des pièces du fait des gradients de dépôt et/ou des contraintes internes au matériau. L'utilisation de tels outils pénalise le taux de chargement de la chambre.

Des procédés et installations de densification de substrats annulaires poreux par infiltration chimique en phase vapeur sont notamment décrits dans les documents US 2004 237898 et US 5 904 957. Cependant, ces procédés s'appliquent essentiellement à la densification de substrats de forme annulaire disposés en piles et ne sont pas adaptés pour la densification de substrats présentant des formes minces.

### Objet et résumé de l'invention

L'invention a pour but de fournir un procédé qui permet de densifier des substrats poreux minces, c'est-à-dire des substrats présentant une faible épaisseur par rapport aux dimensions de leurs faces principales telles que des pièces fines planes ou courbées, avec une capacité de chargement élevée, et ce en réduisant les gradients de densification dans les substrats.

Ce but est atteint avec un procédé d'infiltration chimique en phase vapeur pour la densification de substrats poreux minces par un matériau déposé au sein de ceux-ci, le procédé comprenant : le chargement des substrats à densifier à l'intérieur d'une chambre de réaction d'un four d'infiltration ; l'admission, au voisinage d'une première extrémité longitudinale de la chambre de réaction, d'un gaz réactif contenant au moins un précurseur du matériau à déposer ; et l'évacuation de gaz résiduels à travers une sortie située au voisinage de l'extrémité longitudinale de la chambre de réaction opposée à la première,
procédé dans lequel, conformément à l'invention, les substrats sont disposés radialement autour d'un conduit longitudinal, le gaz réactif étant ensuite distribué le long des faces principales des substrats suivant une direction d'écoulement essentiellement radiale.

Ainsi, la direction d'écoulement du gaz réactif le long des substrats est maîtrisée et, par conséquent, l'uniformité de densification de ces derniers. La distribution du gaz réactif est réalisée au plus près des faces des substrats, ce qui permet de réduire l'appauvrissement local du gaz en réactif qui est observé lorsque les substrats sont proches les uns des autres et que le flux n'est pas dirigé. La diffusion des espèces réactives au sein des substrats est plus importante.

Le procédé selon l'invention permet, par conséquent, de réaliser la densification de substrats poreux minces, et ce en augmentant la qualité des pièces obtenues ainsi que le volume de chargement de la chambre de réaction.

En outre, le gaz réactif peut être préchauffé avant d'être distribué le long des substrats. De cette manière, la zone de préchauffage habituellement utilisée dans les chambres de réaction avec les procédés à flux libre n'est plus nécessaire, ce qui permet d'augmenter encore le volume de chargement de la chambre.

Le gaz réactif peut être distribué à partir du conduit, à savoir au niveau des bords internes des substrats, et être évacué au niveau des bords externes des substrats. A l'inverse, le gaz réactif admis dans la chambre peut être distribué à partir des bords externes des substrats et être évacué par l'intérieur du conduit longitudinal. Dans les deux cas, le gaz circule le long des faces principales des substrats suivant une direction d'écoulement essentiellement radiale.

Lorsque le gaz réactif est distribué à partir du conduit, l'agencement radial des substrats offre une répartition locale des substrats en adéquation avec l'appauvrissement du gaz lors de son parcours le long des faces de ceux-ci. En effet, lors de sa sortie du conduit, le gaz présente la composition la plus riche alors qu'il se trouve dans la zone ayant le taux de chargement en substrats le plus important. Le gaz s'appauvrie ensuite lors de son parcours le long des faces des substrats qui s'écartent progressivement les unes des autres réduisant ainsi le taux de chargement local. Cette compensation mutuelle peut être utile lorsque le gaz réactif présente une composition de départ déjà faible en espèces réactives.

Des inserts en forme de dièdre peuvent être disposés entre deux substrats adjacents de manière à favoriser l'écoulement du gaz réactif au plus près des faces des substrats.

En fonction des dimensions internes de la chambre de réaction, il est possible de superposer et/ou de juxtaposer plusieurs séries de substrats dans le volume interne de la chambre. Dans chaque pile, les conduits longitudinaux communiquent entre eux pour former un canal unique de distribution ou d'évacuation du gaz réactif.

Dans le cas de substrats de petites dimensions, une ou plusieurs rangées supplémentaires de substrats peuvent être juxtaposées, chaque substrat de la rangée supplémentaire étant alors dans le même plan radial qu'un substrat de la rangée adjacente pour ne pas perturber l'écoulement radial du gaz réactif.

L'invention a également pour objet de fournir un outillage de chargement qui permet de mettre en oeuvre le procédé défini ci-dessus.

Ce but est atteint avec un dispositif de chargement qui comprend un conduit tubulaire disposé entre des premier et second plateaux, le conduit tubulaire débouchant à la surface d'au moins un des plateaux pour permettre l'admission ou l'évacuation d'un gaz réactif dans ledit conduit, chaque plateau comprenant des moyens pour maintenir les substrats dans une position radiale autour dudit conduit, le conduit tubulaire comportant une pluralité d'orifices pour distribuer ou évacuer le gaz réactif le long des faces principales des substrats suivant une direction d'écoulement essentiellement radiale.

Une fois disposé dans une chambre de réaction, ce dispositif agit comme un miniréacteur dans lequel l'écoulement du gaz est maîtrisé comme décrit précédemment. Avec ce dispositif, le chargement des substrats peut être préparé à l'avance en dehors des installations de densification et transporté facilement sans risque jusque dans la chambre de réaction. Ainsi, les temps de chargement/déchargement des chambres de réaction sont réduits.

Les orifices du conduit tubulaire sont de préférence disposés de manière à distribuer ou à évacuer le gaz réactif au plus près des faces des substrats.

Selon un aspect de l'invention, le dispositif comprend en outre une enveloppe cylindrique externe entourant les substrats et disposée concentriquement au conduit tubulaire, l'enveloppe comportant une pluralité d'orifices pour l'évacuation ou la distribution du gaz réactif. Les orifices de l'enveloppe cylindrique sont de préférence disposés au plus près du bord externe des substrats pour favoriser l'écoulement du gaz réactif au plus près des faces des substrats.

Les premier et second plateaux comprennent chacun des moyens pour maintenir les substrats en position radiale autour du conduit tubulaire. Ces moyens peuvent être notamment des glissières ou des couronnes munies d'encoches dans lesquelles s'engagent les substrats.

L'invention a encore pour objet une installation permettant la densification uniforme de substrats poreux minces par infiltration chimique en phase vapeur, et ce avec une capacité de chargement élevée.

Ce but est atteint grâce à une installation comportant une chambre de réaction à l'intérieur de laquelle se trouve une zone de chargement de substrats à densifier, un suscepteur délimitant la chambre et associé à des moyens de chauffage, une entrée d'admission en gaz réactif à une première extrémité longitudinale de la chambre, et une sortie d'évacuation située au voisinage de l'extrémité longitudinale de la chambre de réaction opposée à la première,
caractérisée en ce que la chambre comprend une pluralité de substrats poreux minces disposés dans au moins un dispositif de chargement tel que décrit ci-dessus, le conduit tubulaire du dispositif étant raccordé à l'entrée d'admission ou à la sortie d'évacuation de la chambre.

Suivant ses dimensions, la chambre peut comprendre plusieurs dispositifs de chargement empilés les uns sur les autres et/ou juxtaposés, le conduit tubulaire d'un dispositif de chargement coopérant avec le conduit tubulaire du dispositif sur lequel il est empilé et le conduit tubulaire du dispositif de chargement situé au sommet d'un empilement étant raccordé à l'entrée d'admission ou à la sortie d'évacuation de la chambre.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels:
- les figures 1A à 1C sont des vues en perspective d'un outillage utilisé pour le chargement et la densification de substrats poreux minces conformément à l'invention ;
- la figure 2 est une vue en perspective d'une partie de l'outillage de la figure 1A montrant une variante de réalisation des moyens de maintien et de positionnement des substrats ;
- la figure 3 est une vue schématique en coupe montrant une installation de densification par infiltration chimique en phase vapeur dans laquelle des substrats sont chargés au moyen d'un outillage selon l'invention ;
- la figure 4A est une vue en coupe de l'installation de la figure 3;
- la figure 4B est une vue de détail d'une partie de la figure 4A;
- la figure 4C montre l'écoulement d'un gaz réactif en présence d'inserts;
- la figure 5 est une vue schématique en coupe montrant une installation de densification par infiltration chimique en phase vapeur dans laquelle le sens de circulation du gaz réactif est inversé par rapport à l'installation de la figure 3;
- la figure 6 est une vue schématique en coupe montrant une installation de densification par infiltration chimique en phase vapeur dans laquelle sont superposés et juxtaposés plusieurs outillages selon l'invention ;
- la figure 7 est une vue en coupe de l'installation de la figure 6; et
- les figures 8A et 8B montrent respectivement les résultats obtenus avec un procédé de densification par infiltration chimique en phase vapeur à flux libre et avec un procédé de densification par infiltration chimique en phase vapeur conforme à l'invention.

### Description détaillée de mode de réalisation

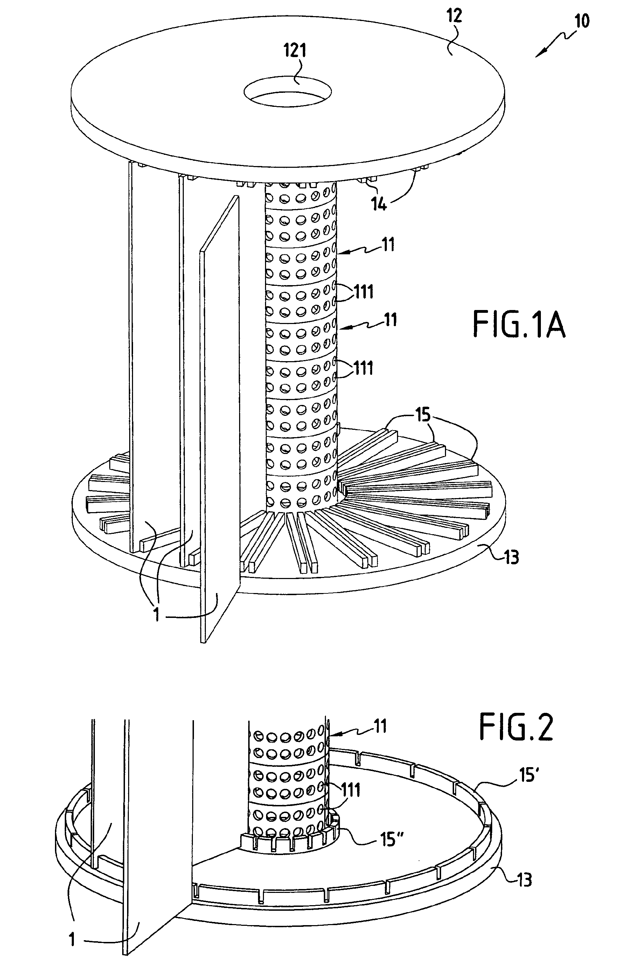

Le procédé d'infiltration chimique en phase vapeur pour la densification de substrats poreux minces conformément à l'invention met en oeuvre un outillage de chargement spécifique dont la structure et le montage sont décrits en relation avec les figures 1A à 1C.

La figure 1A représente un dispositif ou outillage de chargement 10 au début de l'opération de chargement de substrats à densifier 1, c'est-à-dire avant la fermeture de l'outillage et son introduction dans une chambre de réaction d'une installation industrielle d'infiltration chimique en phase vapeur. L'outillage 10 comprend un conduit tubulaire vertical 11 disposé entre deux plateaux circulaires 12 et 13. L'extrémité supérieure du conduit 11 coopère avec une ouverture centrale 121 ménagée dans le plateau 12, l'extrémité inférieure du conduit 11 est fermée par le plateau 13. Selon une variante, l'extrémité inférieure du conduit 11 peut coopérer avec une ouverture centrale ménagée dans le plateau 13 pour permettre notamment la superposition des outillages dans une chambre de réaction comme expliqué plus loin.

Les faces latérales en regard des plateaux 12 et 13 comportent chacune des moyens de maintien et de positionnement destinés à recevoir les substrats à densifier. Dans le mode de réalisation présenté sur la figure 1A, le plateau 12, respectivement 13, comprend une pluralité de glissières 14, respectivement 15, uniformément réparties radialement autour du conduit 11. Les substrats à densifier 1 sont chargés un à un dans l'outillage en les engageant dans les glissières. D'autres dispositifs peuvent être utilisés pour maintenir en position les substrats. Par exemple, comme illustré sur la figure 2, les glissières peuvent être remplacées par des couronnes 15', 15" qui comportent des encoches dans lesquelles sont engagés les substrats. Selon une autre variante, les plateaux peuvent être munis de cavaliers éventuellement de différentes dimensions ou réglables en hauteur pour recevoir des substrats de tailles différentes. Ces dispositifs peuvent être rapportés sur les plateaux ou faire partie intégrante de ceux-ci (usinage dans la masse).

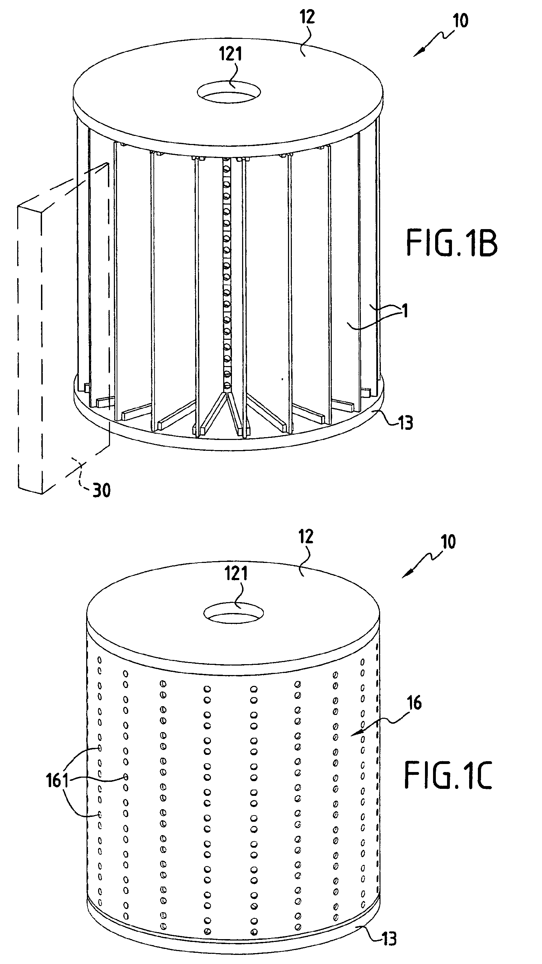

La figure 1B représente l'outillage 10 lorsque tous les substrats 1 ont été chargés. On constate que ceux-ci sont uniformément répartis radialement autour du conduit 11. Une fois complètement chargé, l'outillage 10 est fermé par une enveloppe cylindrique 16 comme illustré sur la figure 1C. L'outillage 10 forme alors une cellule qui protège les substrats. Ces derniers peuvent être ainsi facilement transportés jusqu'à la chambre de réaction. Tous les éléments de l'outillage 10 (plateaux, conduit tubulaire, moyens de maintien des substrats, enveloppe cylindrique, ...) sont par exemple en graphite, en graphite expansé ou en un matériau composite C/C.

De façon optionnelle, des inserts 30 en forme de dièdre peuvent être disposés entre deux substrats adjacents de manière à favoriser l'écoulement du gaz réactif au plus près des faces des substrats. Comme les autres éléments de l'outillage 10, les inserts 30 peuvent être par exemple en graphite, en graphite expansé ou en un matériau composite C/C.

Le conduit 11, qui est destiné à distribuer ou à évacuer le gaz réactif comme expliqué plus loin, comporte une pluralité d'orifices 111 pour permettre le passage de ce gaz. Les orifices 111 sont de préférence disposés suivant des lignes parallèles à l'axe du tube uniformément espacées les unes des autres sur le pourtour du conduit et avec un espace constant entre les orifices d'une même ligne.

L'enveloppe cylindrique 16 est également munie d'orifices 161 pour permettre l'évacuation ou la distribution du gaz respectivement hors ou dans l'outillage ainsi que leur circulation dans la chambre de réaction. Le nombre et le positionnement angulaire des orifices 161 sur l'enveloppe 16 sont de préférence choisis pour être alignés un à un avec les orifices 111 du conduit 11.

Le conduit tubulaire 11 et l'enveloppe cylindrique 16 peuvent être formés de plusieurs sections raccordées bout à bout permettant une construction modulaire.

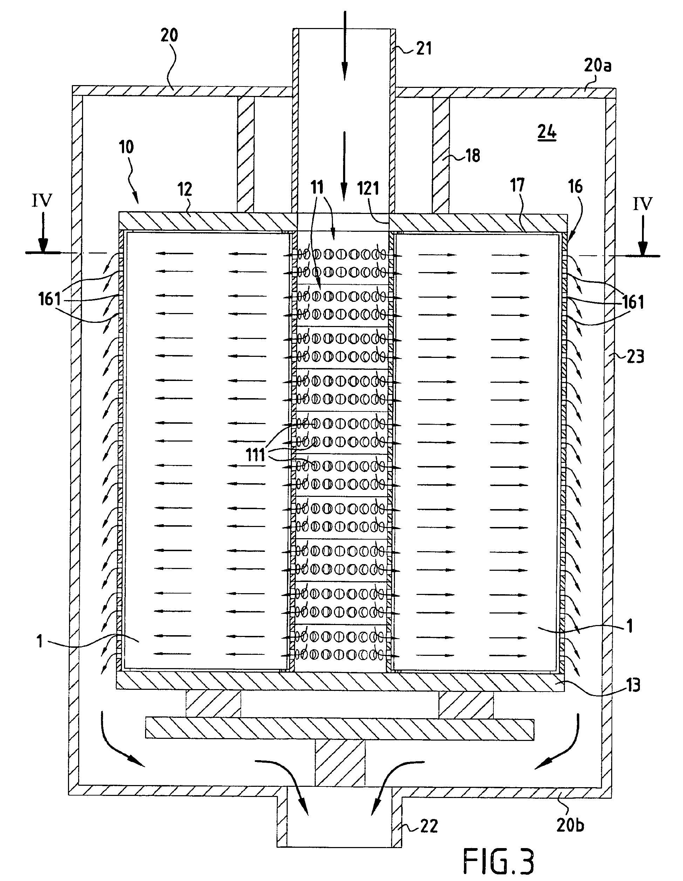

La figure 3 représente schématiquement une chambre de réaction 20 d'une installation ou four d'infiltration chimique en phase vapeur dans laquelle sont chargés des substrats à densifier. La chambre 20 a une forme généralement cylindrique.

Afin d'assurer la densification des substrats 1, un gaz réactif contenant un ou plusieurs précurseurs du matériau de la matrice à déposer est introduit dans la chambre 20. Dans le cas du carbone par exemple, on utilise des composés gazeux hydrocarbonés, typiquement du propane, du méthane ou un mélange des deux. Dans le cas d'un matériau céramique, comme du carbure de silicium (SiC) par exemple, on peut utiliser, comme bien connu en soi, du méthyltrichlorosilane (MTS) en tant que précurseur de SiC.

La densification des substrats poreux 1 est assurée, de façon bien connue en soi, par dépôt au sein de ceux-ci du matériau de la matrice produit par décomposition du précurseur contenu dans le gaz réactif diffusant à l'intérieur de la porosité interne accessible des substrats. Les conditions de pression et de température nécessaires pour obtenir des dépôts de matrices diverses par infiltration chimique en phase vapeur sont biens connues en elles-mêmes.

Dans l'exemple illustré, le gaz réactif est amené par une conduite 21 qui débouche dans la partie supérieure de la chambre. Le gaz résiduel est extrait à la partie inférieure de la chambre par une conduite 22.

Le chauffage à l'intérieur de la chambre est produit par un suscepteur en graphite 23 formant un induit couplé électromagnétiquement avec un inducteur (non représenté). Le suscepteur 23 délimite le volume interne 24 de la chambre d'axe vertical avec le couvercle 20a traversé par la conduite 21 et le fond 20b traversé par la conduite 22. Le fond et le couvercle sont également en graphite.

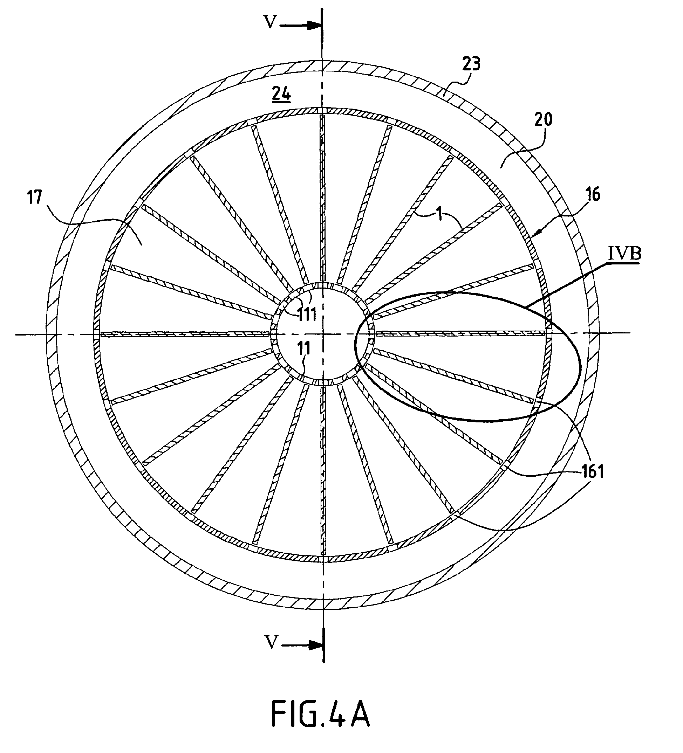

Afin de réaliser la densification de substrats poreux minces suivant un procédé conforme à l'invention, ces derniers sont chargés à l'intérieur de la chambre 20 au moyen de l'outillage de chargement 10 tel que décrit précédemment. Comme illustré sur les figures 3 et 4A, l'axe du conduit 11 coïncide avec l'axe de la chambre de sorte que les substrats 1 sont disposés longitudinalement suivant cet axe et s'étendent radialement autour de celui-ci à partir de la paroi externe du conduit 11. Les substrats sont contenus dans un volume interne 17 délimité par le conduit 11, l'enveloppe 16 et les plateaux 12 et 13, ce volume définissant la zone de réaction pour la densification des substrats.

La conduite 21 de la chambre est raccordée au conduit 11 de l'outillage qui forme une zone de préchauffage pour le gaz réactif avant sa distribution vers les substrats 1. Un manchon 18, destiné à former une chambre de préchauffage, peut être en outre disposé sur la partie supérieure du plateau 12 autour de l'ouverture 121. Le gaz réactif préchauffé est distribué dans le volume interne 17 par passage à travers les orifices 111 du conduit 11 et passe de ce volume au volume interne 24 de la chambre en diffusant à travers les substrats 1 et en passant à travers les orifices 161 de l'enveloppe 16. Le gaz résiduel est extrait au niveau du fond 20b de la chambre à travers la conduite 22 qui est reliée à des moyens d'aspiration (non représentés).

La distribution du gaz réactif par passage à travers les orifices 111 du conduit 11 permet d'imposer à ce dernier un écoulement essentiellement radial dans la zone de réaction. On maîtrise ainsi la direction d'écoulement du gaz par rapport à la géométrie des substrats, ce qui permet d'avoir un appauvrissement du gaz sensiblement uniforme sur toute la largeur des substrats.

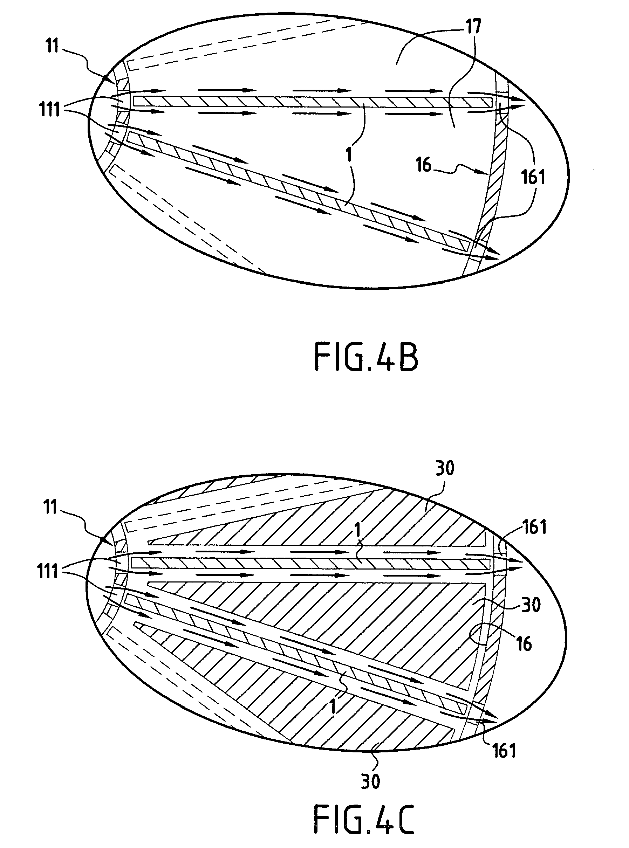

En outre, l'outillage de chargement permet le transport du gaz réactif au plus près des substrats. Comme illustré sur les figures 4A et 4B, le gaz réactif est distribué à partir du conduit 11 en passant à travers les orifices 111 en face ou à proximité desquels se trouvent les bords intérieurs des substrats. De même, les orifices 161 de l'enveloppe 16 par lesquels le gaz est évacué de la zone réactive sont situés en face ou à proximité des bords extérieurs des substrats. De cette manière, l'écoulement du gaz réactif s'effectue principalement le long des parois des substrats, ce qui permet d'optimiser la quantité d'espèces réactives diffusées dans les substrats et de réduire la couche limite de diffusion. Un gradient de pression peut être éventuellement maintenu entre le conduit 11 et le volume interne 17. Par ailleurs, la perte de charge est contrôlée par le diamètre des orifices qui peut varier de manière à équilibrer les écoulements au sein de la zone de réaction le cas échéant.

La figure 4C montre l'écoulement du gaz réactif lorsque des inserts 30 ont été disposés entre les substrats. La forme en dièdre des inserts 30 permet de réduire le volume entre les substrats de manière à favoriser l'écoulement du gaz réactif au plus près des faces des substrats.

Un autre avantage de l'outillage de chargement est la possibilité d'avoir une bonne adéquation entre la composition du gaz réactif et le taux de chargement local. En effet, lorsque le gaz réactif est introduit à partir du conduit tubulaire 11, à savoir la zone dans laquelle le taux de chargement local est le plus important en raison de l'agencement radial des substrats (forte proximité des substrats), il présente une composition riche en réactif. Par conséquent, avant son appauvrissement, le gaz est distribué dans la zone la plus chargée en substrats. A l'inverse, à la périphérie de l'outillage, le gaz présente une composition appauvrie en réactif, des espèces réactives ayant été consommées lors du passage dans la zone de réaction. Cet appauvrissement est compensé par le taux local de chargement qui est plus faible (divergence entre les substrats). Cette compensation n'est utile que lorsque le gaz présente une composition au départ déjà faible en espèces réactives. Les risques d'appauvrissement prématuré du gaz en espèces réactives peuvent être éliminés en choisissant un gaz ayant une concentration en espèces réactives supérieure à ce qui doit être consommé lors de l'infiltration.

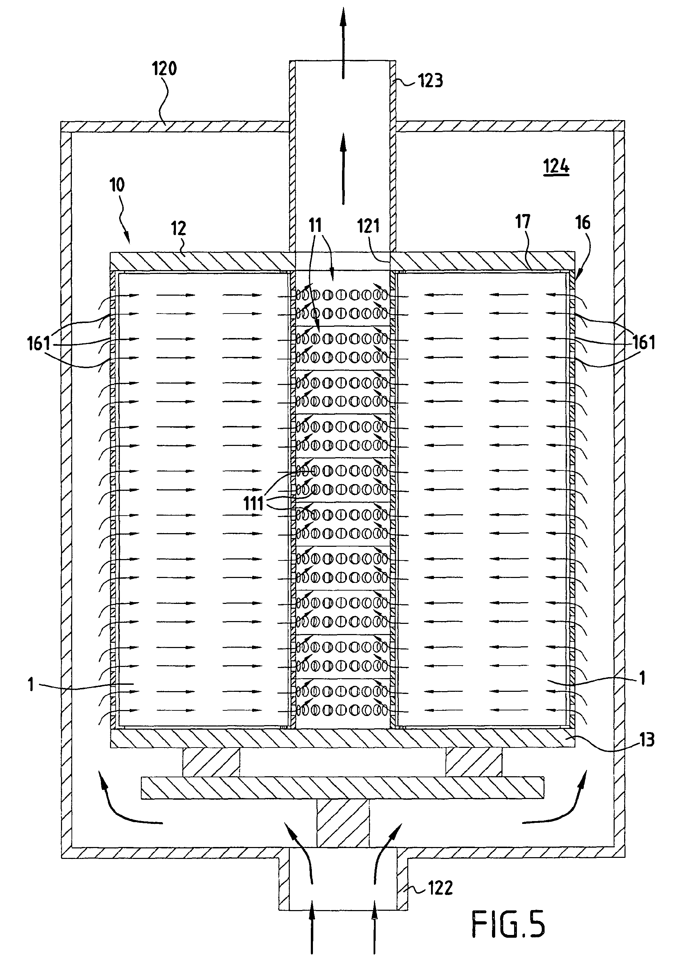

Selon une variante de mise en oeuvre du procédé de l'invention, le gaz réactif peut être distribué à partir des bords externes des substrats et évacués par le conduit tubulaire 11. Dans ce cas, comme illustré sur la figure 5, l'outillage de chargement 10 est disposé à l'intérieur d'une chambre de réaction 120 qui diffère de la chambre 20 précédemment décrite en ce que le gaz réactif est admis dans le volume interne 124 de la chambre par une conduite 122 et est évacué par une conduite 123 qui est raccordée au conduit 11 de l'outillage 10. Dans cette configuration, le gaz réactif admis dans la chambre par la conduite 122 circule dans le volume interne 124 de la chambre et pénètre dans le volume interne 17 de l'outillage par les orifices 161 de l'enveloppe 16. Le gaz circule ensuite le long des faces des substrats suivant une direction sensiblement radiale. Le gaz est évacué du volume 17 par le conduit 11 en passant par les orifices 111 de celui-ci.

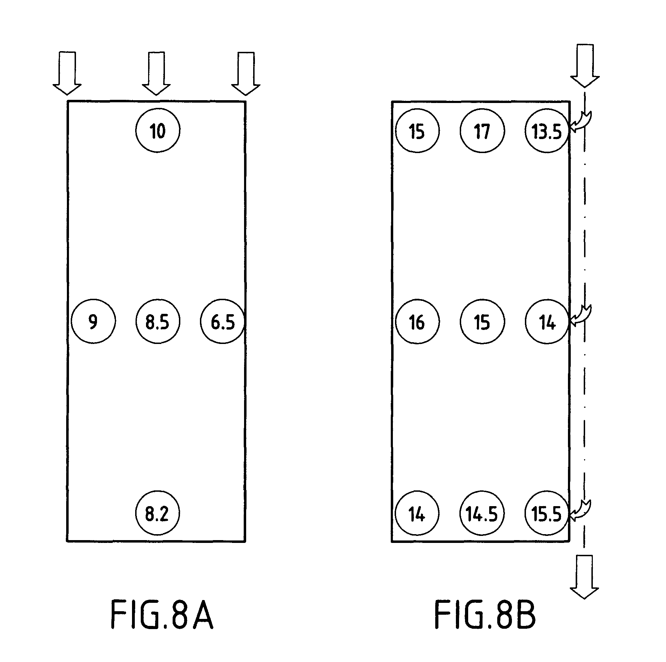

Ainsi, avec le procédé de densification par infiltration chimique de l'invention, on réalise une meilleure infiltration des textures des substrats en comparaison avec les procédés à flux libre. Les figures 8A et 8B montrent respectivement les résultats obtenus après une densification par infiltration chimique réalisée avec un procédé de densification par infiltration chimique en phase vapeur à flux libre (figure 8A) et avec un procédé de densification par infiltration chimique en phase vapeur conforme à l'invention (figure 8B). Les essais ont été réalisés sur des substrats identiques formés d'une texture tissée en fibre de carbone en forme de pièces planes rectangulaires (230x110 mm) de type "volet de tuyère", la composition des dépôts réalisés dans les substrats étant la même. Les chiffres indiqués sur les substrats des figures 8A et 8B représentent l'épaisseur totale à coeur (en µm) mesurée à différents endroits des substrats. On constate que l'épaisseur à coeur du substrat de la figure 8B (procédé de l'invention) est bien supérieure en moyenne à l'épaisseur du substrat de la figure 8A (flux libre). Par ailleurs, la dispersion de densification est moins importante dans le substrat de la figure 8B que dans celui de la figure 8A.

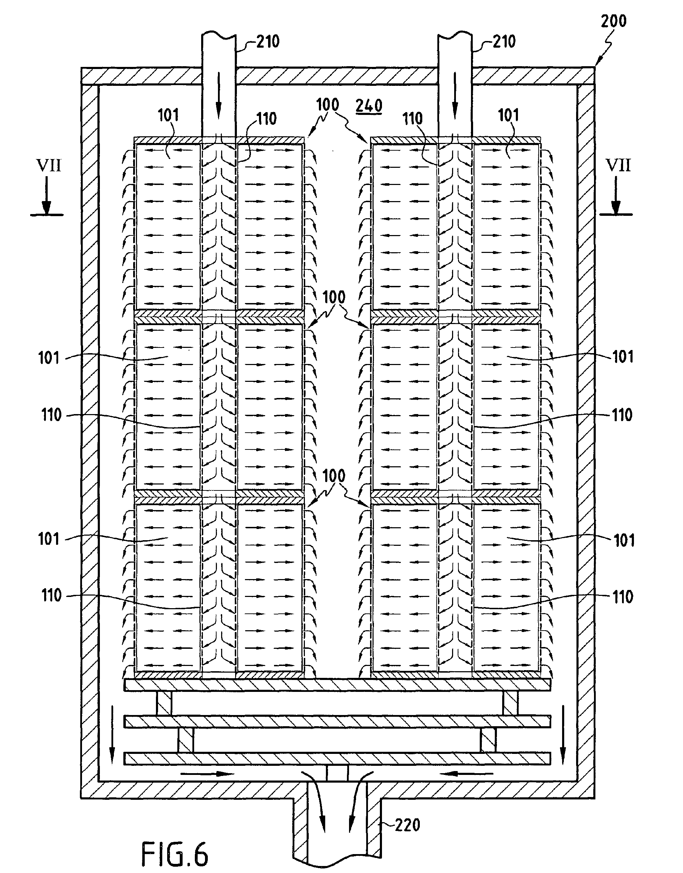

L'outillage de chargement se comporte comme un miniréacteur qui permet d'optimiser les paramètres de densification de façon indépendante. Par conséquent, lorsque la capacité de la chambre de réaction le permet, plusieurs outillages peuvent être superposés et/ou juxtaposés dans une même chambre. La figure 6 illustre une chambre de réaction 200 dans laquelle plusieurs outillages de chargement 100 sont disposés en plusieurs piles. La structure et le fonctionnement des outillages 100 sont quasiment similaires à ceux de l'outillage 10 décrit précédemment. La différence est que le conduit tubulaire 110 des outillage 100 débouche des deux côtés de l'outillage afin que tous les conduits d'une même pile coopèrent un à un pour permettre la distribution du gaz réactif dans toutes les zones de réaction des outillages. L'outillage au sommet de chaque pile est raccordé par l'extrémité supérieure de son conduit 110 à une conduite 210 d'admission en gaz réactif de la chambre. Le gaz résiduel est évacué par une conduite 220 au fond de la chambre. Alternativement, comme expliqué précédemment en relation avec la figure 5, le sens de circulation du gaz réactif peut être inversé de manière à s'écouler depuis les bords externes des substrats vers les bords internes de ces derniers. Dans ce cas, l'extrémité supérieure du conduit de l'outillage au sommet de la pile est raccordé au conduit d'évacuation de la chambre.

Dans le cas d'un chargement multiple constitué de plusieurs outillages, l'adaptation du procédé consiste seulement à alimenter en gaz réactif chaque miniréacteur constitué par un outillage. Les débits de gaz réactif sont simplement multipliés par le nombre d'outillages à alimenter. Par ailleurs, les problèmes d'écoulement en zone morte rencontrés avec les procédés à flux libre dans les chambres de réaction de grandes tailles sont éliminés par l'utilisation des outillages de chargement de l'invention.

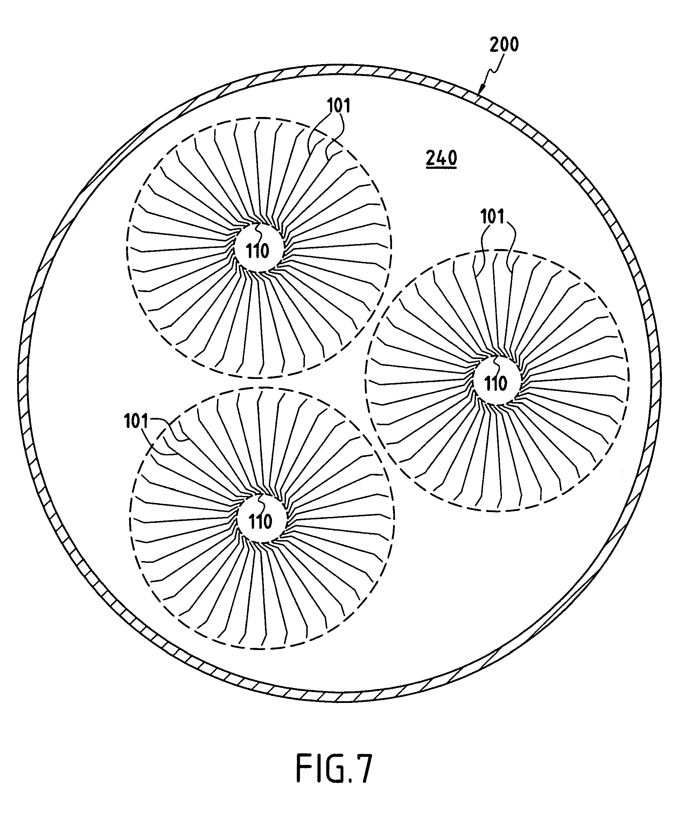

Le procédé de densification par infiltration chimique de l'invention est particulièrement adapté pour des préformes ou substrats poreux qui présentent une forme mince, c'est-à-dire ayant une faible épaisseur par rapport à ses autres dimensions (longueur/largeur des faces). De tels substrats peuvent être par exemple des pièces rectangulaires ou carrées sensiblement planes ou présentant des courbures tels que les substrats 101 présentés en figures 6 et 7 qui présentent des bords tombés aux extrémités. Le procédé de densification de l'invention peut être utilisé notamment pour la fabrication de pièces minces en matériau composite à matrice céramique (CMC) telles que des volets de tuyère aéronautique.

L'outillage de chargement de l'invention présente en outre l'intérêt de permettre la préparation du chargement à l'avance, c'est-à-dire en dehors du local technique du four d'infiltration et de transporter les substrats à densifier avec un moindre risque jusque dans la chambre de réaction, contrairement aux outillages standards habituellement utilisés en flux libre. Le temps de chargement/déchargement des fours d'infiltration chimique en phase gazeuse est ainsi réduit et les manipulations facilitées.

Le préchauffage du gaz à l'intérieur du conduit de l'outillage ou dans le volume interne de la chambre entre la paroi interne de la chambre et l'enveloppe externe de l'outillage permet de s'affranchir d'une zone de préchauffage habituellement utilisée avec les procédés d'infiltration chimique en phase vapeur à flux libre. Le volume utile de la chambre s'en trouve ainsi augmenté, ce qui permet d'accroître le taux de chargement du four.

## Revendications

1. Procédé d'infiltration chimique en phase vapeur pour la densification de substrats poreux minces (1) par un matériau déposé au sein de ceux-ci, le procédé comprenant : le chargement des substrats (1) à densifier à l'intérieur d'une chambre de réaction (20) d'un four d'infiltration ; l'admission, au voisinage d'une première extrémité longitudinale (21) de la chambre de réaction, d'un gaz réactif contenant au moins un précurseur du matériau à déposer ; et l'évacuation de gaz résiduels à travers une sortie (22) située au voisinage de l'extrémité longitudinale de la chambre de réaction opposée à la première,
ledit procédé étant **caractérisé en ce que** les substrats (1) sont disposés radialement autour d'un conduit longitudinal (11), le gaz réactif étant ensuite distribué le long des faces principales des substrats (1) suivant une direction d'écoulement essentiellement radiale.

2. Procédé selon la revendication 1, **caractérisé en ce que** le gaz réactif admis dans la chambre (20) est distribué à partir du conduit longitudinal (11).

3. Procédé selon la revendication 2, **caractérisé en ce que** l'évacuation du gaz réactif à l'extrémité externe des substrats est réalisée au plus près des faces principales des substrats (1).

4. Procédé selon la revendication 2 ou 3, **caractérisé en ce que** le gaz réactif est préchauffé dans le conduit longitudinal (11) avant d'être distribué le long des substrats (1).

5. Procédé selon la revendication 1, **caractérisé en ce que** le gaz réactif admis dans la chambre (20) est distribué à partir des bords externes des substrats (1), le gaz réactif étant évacué par le conduit longitudinal (11).

6. Procédé selon l'une des revendications 1 à 5, **caractérisé en que** l'on dispose des inserts (30) en forme de dièdre entre les substrats (1).

7. Procédé selon l'une quelconque des revendications 1 à 6, **caractérisé en ce qu'**il comprend en outre la superposition dans la chambre de réaction (200) d'une ou plusieurs séries de substrats (101) disposés radialement autour d'un conduit longitudinal (110), chaque conduit longitudinal d'une série de substrats coopérant avec le conduit longitudinal de la série sur laquelle il est superposé.

8. Procédé selon l'une quelconque des revendications 1 à 7, **caractérisé en ce qu'**il comprend en outre la juxtaposition dans la chambre (200) de plusieurs séries de substrats (101) disposés radialement autour d'un conduit longitudinal (110), chaque conduit longitudinal délimité par une série de substrats recevant ou évacuant une partie du gaz réactif admis dans la chambre (200).

9. Procédé selon l'une quelconque des revendications 1 à 8, **caractérisé en ce qu'**il comprend en outre la juxtaposition d'au moins une rangée supplémentaire de substrats, chaque substrat de la rangée supplémentaire étant dans le même plan radial qu'un substrat de la rangée adjacente.

10. Dispositif de chargement (10) pour la densification de substrats poreux minces (1) par infiltration chimique en phase vapeur dans une chambre de réaction (20) d'un four d'infiltration, **caractérisé en ce qu'**il comprend un conduit tubulaire (11) disposé entre des premier et second plateaux (12, 13), le conduit tubulaire (11) débouchant à la surface d'au moins un (12) des plateaux pour permettre l'admission ou l'évacuation d'un gaz réactif dans ledit conduit, chaque plateau comprenant des moyens pour maintenir les substrats (1) dans une position radiale autour dudit conduit (11) et **en ce que** le conduit tubulaire comporte une pluralité d'orifices (111) pour distribuer ou évacuer le gaz réactif le long des faces principales des substrats (1) suivant une direction d'écoulement essentiellement radiale.

11. Dispositif selon la revendication 10, **caractérisé en ce que** les orifices (111) du conduit tubulaire sont disposés de manière à distribuer ou à évacuer le gaz réactif le long des faces des substrats (1).

12. Dispositif selon la revendication 10 ou 11, **caractérisé en ce qu'**il comprend en outre une enveloppe cylindrique externe (16) entourant les substrats (1) et disposée concentriquement au conduit tubulaire (11), l'enveloppe comportant une pluralité d'orifices (161) pour l'évacuation ou la distribution du gaz réactif.

13. Dispositif selon la revendication 12, **caractérisé en ce que** les orifices (161) de l'enveloppe cylindrique (16) sont disposés au plus près du bord externe des substrats.

14. Dispositif selon l'une quelconque des revendications 10 à 13, **caractérisé en ce qu'**il comprend en outre des inserts (30) en forme de dièdre disposés entre les substrats (1).

15. dispositif selon l'une des revendications 10 à 14, **caractérisé en ce que** les premier et second plateaux (12, 13) comprennent chacun une pluralité de glissières (14, 15) disposées radialement autour du conduit tubulaire dans lesquelles s'engagent les substrats.

16. Dispositif selon l'une des revendications 10 à 15, **caractérisé en ce que** les premier et second plateaux comprennent chacun deux couronnes concentriques (15', 15") comportant un nombre équivalent d'encoches alignées radialement deux à deux et dans lesquelles s'engagent les substrats.

17. Installation de densification de substrats poreux minces (1) par infiltration chimique en phase vapeur, comportant une chambre de réaction (20) à l'intérieur de laquelle se trouve une zone de chargement de substrats à densifier, un suscepteur (23) délimitant la chambre et associé à des moyens de chauffage, une entrée d'admission en gaz réactif (21) à une première extrémité longitudinale de la chambre, et une sortie d'évacuation (22) située au voisinage de l'extrémité longitudinale de la chambre de réaction opposée à la première,
**caractérisée en ce que** la chambre (20) comprend une pluralité de substrats (1) poreux minces disposés dans au moins un dispositif de chargement (10) selon l'une quelconque des revendication 10 à 16, le conduit tubulaire (11) du dispositif étant raccordé à l'entrée d'admission (21) ou à la sortie d'évacuation (22) du gaz réactif de la chambre (20).

18. Installation selon la revendication 17, **caractérisée en ce que** la chambre (200) comprend plusieurs dispositifs de chargement (100) empilés les uns sur les autres, le conduit tubulaire (110) d'un dispositif de chargement (100) coopérant avec le conduit tubulaire du dispositif sur lequel il est empilé et le conduit tubulaire du dispositif de chargement situé au sommet de l'empilement étant raccordé à l'entrée d'admission (210) ou à la sortie d'évacuation (220) du gaz réactif de la chambre.

19. Installation selon la revendication 17 ou 18, **caractérisée en ce que** la chambre (200) comprend plusieurs dispositifs de chargement juxtaposés (100), le conduit tubulaire (110) de chaque dispositif de chargement (100) étant raccordé à une entrée d'admission (210) ou à la sortie d'évacuation (220) du gaz réactif de la chambre.

## Claims

1. A chemical vapor infiltration method for densifying thin porous substrates (1) with a material that is deposited therein, the method comprising: loading substrates (1) for densification inside a reaction chamber (20) of an infiltration oven; admitting close to a first longitudinal end (21) of the reaction chamber a reactive gas containing at least one precursor of the material to be deposited; and removing the residual gas through an outlet (22) situated close to the longitudinal end of the reaction chamber opposite its first end,
said method being **characterized in that** the substrates (1) are disposed radially around a longitudinal duct (11), the reactive gas then being distributed along the main faces of the substrates (1) in a flow direction that is essentially radial.

2. A method according to claim 1, **characterized in that** the reactive gas admitted in the chamber (20) is distributed from the longitudinal duct (11).

3. A method according to claim 2, **characterized in that** the reactive gas is removed from the outer ends of the substrates as close as possible to the main faces of the substrates (1).

4. A method according to claim 2 or claim 3, **characterized in that** the reactive gas is preheated in the longitudinal duct (11) prior to being distributed along the substrates (1).

5. A method according to claim 1, **characterized in that** the reactive gas admitted into the chamber (20) is distributed from the outer edges of the substrates (1), the reactive gas being removed via the longitudinal duct (11).

6. A method according to any one of claims 1 to 5, **characterized in that** wedge-shaped inserts (30) are disposed between the substrates (1).

7. A method according to any one of claims 1 to 6, **characterized in that** it further includes superposing within the reaction chamber (200) one or more sets of substrates (101) disposed radially around a longitudinal duct (110), each longitudinal duct of a set of substrates co-operating with the longitudinal duct of the series on which it is superposed.

8. A method according to any one of claims 1 to 7, **characterized in that** it further includes juxtaposing within the chamber (200) a plurality of sets of substrates (101) disposed radially around a longitudinal duct (110), each longitudinal duct defined by a set of substrates receiving or removing a fraction of the reactive gas admitted into the chamber (200).

9. A method according to any one of claims 1 to 8, **characterized in that** it further includes juxtaposing at least one additional row of substrates, each substrate of the additional row lying in the same radial plane as a substrate of the adjacent row.

10. A loading device (10) for densifying thin porous substrates (1) by chemical vapor infiltration in a reaction chamber (20) of an infiltration oven, the device being **characterized in that** it comprises a tubular duct (11) disposed between first and second plates (12, 13), the tubular duct (11) opening out in the surface of at least one of the plates (12) in order to enable a reactive gas to be admitted to or removed from said duct, each plate including means for holding the substrates (1) in a radial position around said duct (11), and **in that** the tubular duct has a plurality of orifices (111) for distributing or removing the reactive gas along the main faces of the substrates (1) in a flow direction that is essentially radial.

11. A device according to claim 10, **characterized in that** the orifices (111) in the tubular duct are disposed in such a manner as to distribute or remove the reactive gas along the faces of the substrates (1).

12. A device according to claim 10 or claim 11, **characterized in that** it further includes an outer cylindrical envelope (16) surrounding the substrates (1) and disposed concentrically about the tubular duct (11), the envelope including a plurality of orifices (161) for removing or distributing the reactive gas.

13. A device according to claim 12, **characterized in that** the orifices (161) in the cylindrical envelope (16) are disposed as close as possible to the outside edges of the substrates.

14. A device according to any one of claims 10 to 13, **characterized in that** it further includes wedge-shaped inserts (30) disposed between the substrates (1).

15. A device according to any one of claims 10 to 14, **characterized in that** each of the first and second plates (12, 13) has a plurality of slideways (14, 15) disposed radially about the tubular duct and in which the substrates are engaged.

16. A device according to any one of claims 10 to 15, **characterized in that** each of the first and second plates has two concentric rings (15', 15") with equivalent numbers of notches radially aligned in pairs, in which the substrates are engaged.

17. An installation for densifying thin porous substrates (1) by chemical vapor infiltration, the installation comprising a reaction chamber (20) within which there is a zone for loading substrates for densification, a susceptor (23) defining the chamber and associated with heater means, an admission inlet (21) for reactive gas at a first longitudinal end of the chamber, and a removal outlet (22) situated close to the longitudinal end of the reaction chamber opposite from its first end,
the installation being **characterized in that** the chamber (20) comprises a plurality of thin porous substrates (1) disposed in at least one loading device (10) according to any one of claims 10 to 16, the tubular duct (11) of the device being connected to the admission inlet (21) or to the removal outlet (22) for reactive gas of the chamber (20).

18. An installation according to claim 17, **characterized in that** the chamber (200) contains a plurality of loading devices (100) stacked one on another, the tubular duct (110) of one loading device (100) co-operating with the tubular duct of the device on which it is stacked, and the tubular duct of the loading device situated at the top of the stack being connected to the reactive gas admission inlet (210) or removal outlet (220) of the chamber.

19. An installation according to claim 17 or claim 18, **characterized in that** the chamber (200) contains a plurality of juxtaposed loading devices (100), the tubular duct (110) of each loading device (100) being connected to a reactive gas admission inlet (210) or removal outlet (220) of the chamber.

## Patentansprüche

1. Verfahren zur chemischen Gasphaseninfiltration für die Verdichtung dünner poröser Substrate (1) mittels eines in diesen abgeschiedenen Materials, wobei das Verfahren folgendes umfaßt, nämlich das Einbringen der zu verdichtenden Substrate (1) in eine Reaktionskammer (20) eines Infiltrationsofens; das Zuführen eines reaktiven Gases, das wenigstens einen Vorläufer des abzuscheidenden Materials enthält, in der Nähe eines ersten Längsendes (21) der Reaktionskammer; sowie das Abführen von Restgasen über einen Auslaß (22), der sich in der Nähe des Längsendes der Reaktionskammer befindet, das dem ersten gegenüberliegt,
wobei das Verfahren **dadurch gekennzeichnet ist, daß** die Substrate (1) um eine Längsleitung (11) radial angeordnet sind, wobei das reaktive Gas anschließend entlang der Hauptflächen der Substrate (1) in einer im wesentlichen radialen Strömungsrichtung verteilt wird.

2. Verfahren nach Anspruch 1, **dadurch gekennzeichnet, daß** das in die Kammer (20) eingeleitete reaktive Gas von der Längsleitung (11) aus verteilt wird.

3. Verfahren nach Anspruch 2, **dadurch gekennzeichnet, daß** das Abführen des reaktiven Gases am äußeren Ende der Substrate möglichst nahe den Hauptflächen der Substrate (1) vollzogen wird.

4. Verfahren nach Anspruch 2 oder 3, **dadurch gekennzeichnet, daß** das reaktive Gas vor seiner Verteilung entlang der Substrate (1) in der Längsleitung (11) vorerhitzt wird.

5. Verfahren nach Anspruch 1, **dadurch gekennzeichnet, daß** das in die Kammer (20) eingeleitete reaktive Gas von den Außenrändern der Substrate (1) aus verteilt wird, wobei das reaktive Gas über die Längsleitung (11) abgeführt wird.

6. Verfahren nach einem der Ansprüche 1 bis 5, **dadurch gekennzeichnet, daß** V-förmige Einsätze (30) zwischen den Substraten (1) angeordnet werden.

7. Verfahren nach irgendeinem der Ansprüche 1 bis 6, **dadurch gekennzeichnet, daß** es ferner das Übereinanderanordnen einer oder mehrerer Reihen von um eine Längsleitung (110) radial angeordneten Substraten (101) in der Reaktionskammer (200) umfaßt, wobei jede Längsleitung einer Substratreihe mit der Längsleitung der Reihe zusammenwirkt, über der sie angeordnet ist.

8. Verfahren nach irgendeinem der Ansprüche 1 bis 7, **dadurch gekennzeichnet, daß** es ferner das Nebeneinanderanordnen mehrerer Reihen von um eine Längsleitung (110) radial angeordneten Substraten (101) in der Kammer (200) umfaßt, wobei jede durch eine Substratreihe begrenzte Längsleitung einen Teil des in die Kammer (200) eingeleiteten reaktiven Gases aufnimmt oder abführt.

9. Verfahren nach irgendeinem der Ansprüche 1 bis 8, **dadurch gekennzeichnet, daß** es ferner das Danebenanordnen wenigstens einer zusätzlichen Substratreihe umfaßt, wobei jedes Substrat der zusätzlichen Reihe in der gleichen Radialebene wie ein Substrat der benachbarten Reihe liegt.

10. Beladevorrichtung (10) für die Verdichtung dünner poröser Substrate (1) durch chemische Gasphaseninfiltration in einer Reaktionskammer (20) eines Infiltrationsofens, **dadurch gekennzeichnet, daß** sie eine röhrenförmige Leitung (11) aufweist, die zwischen einer ersten und einer zweiten Platte (12, 13) angeordnet ist, wobei die röhrenförmige Leitung (11) an der Oberfläche wenigstens einer (12) der Platten ausmündet, um das Zuführen oder das Abführen eines reaktiven Gases in die bzw. aus der Leitung zu ermöglichen, wobei jede Platte Mittel zum Halten der Substrate (1) in einer radialen Position um die Leitung (11) umfaßt, und daß die röhrenförmige Leitung eine Vielzahl von Öffnungen (111) aufweist, um das reaktive Gas entlang der Hauptflächen der Substrate (1) in einer im wesentlichen radialen Strömungsrichtung zu verteilen oder abzuführen.

11. Anordnung nach Anspruch 10, **dadurch gekennzeichnet, daß** die Öffnungen (111) der röhrenförmigen Leitung derart angeordnet sind, daß das reaktive Gas entlang der Flächen der Substrate (1) verteilt oder abgeführt wird.

12. Vorrichtung nach Anspruch 10 oder 11, **dadurch gekennzeichnet, daß** sie ferner eine zylindrische Außenhülle (16) aufweist, welche die Substrate (1) umgibt und zu der röhrenförmigen Leitung (11) konzentrisch angeordnet ist, wobei die Hülle eine Vielzahl von Öffnungen (161) für das Abführen oder die Verteilung des reaktiven Gases aufweist.

13. Vorrichtung nach Anspruch 12, **dadurch gekennzeichnet, daß** die Öffnungen (161) der zylindrischen Hülle (16) möglichst nahe dem Außenrand der Substrate angeordnet sind.

14. Vorrichtung nach irgendeinem der Ansprüche 10 bis 13, **dadurch gekennzeichnet, daß** sie ferner zwischen den Substraten (1) angeordnete V-förmige Einsätze (30) umfaßt.

15. Vorrichtung nach einem der Ansprüche 10 bis 14, **dadurch gekennzeichnet, daß** die erste und die zweite Platte (12, 13) jeweils eine Vielzahl von um die röhrenförmige Leitung radial angeordneten Gleitschienen (14, 15) aufweist, in die die Substrate eingreifen.

16. Vorrichtung nach einem der Ansprüche 10 bis 15, **dadurch gekennzeichnet, daß** die erste und die zweite Platte jeweils zwei konzentrische Kränze (15', 15") umfassen, die eine entsprechende Anzahl von Nuten aufweisen, die paarweise radial ausgerichtet sind und in die die Substrate eingreifen.

17. Anlage zur Verdichtung dünner poröser Substrate (1) durch chemische Gasphaseninfiltration, die folgendes umfaßt, nämlich eine Reaktionskammer (20), in der sich ein Bereich zum Beschicken mit zu verdichtenden Substraten befindet, einen Suszeptor (23), der die Kammer begrenzt und Heizmitteln zugeordnet ist, einen Einlaß zum Zuführen von reaktivem Gas (21) an einem ersten Längsende der Kammer sowie einen Abführauslaß (22), der sich in der Nähe des Längsendes der Reaktionskammer befindet, das dem ersten gegenüberliegt,
**dadurch gekennzeichnet, daß** die Kammer (20) eine Vielzahl von dünnen porösen Substraten (1) enthält, die in wenigstens einer Beladevorrichtung (10) nach irgendeinem der Ansprüche 10 bis 16 angeordnet sind, wobei die röhrenförmige Leitung (11) der Vorrichtung an den Eingang zum Zuführen (21) oder an den Auslaß zum Abführen (22) des reaktiven Gases der Kammer (20) angeschlossen ist.

18. Anlage nach Anspruch 17, **dadurch gekennzeichnet**, die Kammer (200) mehrere übereinander gestapelte Beladevorrichtungen (100) enthält, wobei die röhrenförmige Leitung (110) einer Beladevorrichtung (100) mit der röhrenförmigen Leitung der Vorrichtung zusammenwirkt, auf der sie angeordnet ist und wobei die röhrenförmige Leitung der am höchsten Punkt des Stapels befindlichen Beladevorrichtung an den Eingang zum Zuführen (210) oder an den Auslaß zum Abführen (220) des reaktiven Gases der Kammer angeschlossen ist.

19. Anlage nach Anspruch 17 oder 18, **dadurch gekennzeichnet, daß** die Kammer (200) mehrere nebeneinander angeordnete Beladevorrichtungen (100) aufweist, wobei die röhrenförmige Leitung (110) einer jeden Beladevorrichtung (100) an einen Eingang zum Zuführen (210) oder an den Auslaß zum Abführen (220) des reaktiven Gases der Kammer angeschlossen ist.
